# EUROPEAN PATENT APPLICATION

(11) **EP 4 553 265 A2**
(43) Date of publication of application: **14.05.2025**
(21) Application number: 24217415.9
(22) Date of filing: 10.04.2020
(51) Int. Cl.: E06B 3/66

(54) **SPECIFIC COATED GLASS FOR VIG ASSEMBLY**

(30) Priority: 12.04.2019 EP 19168858
(62) Divisional of application: 20717669.4
(71) Applicant: AGC Glass Europe, 1348 Louvain-La-Neuve (BE); AGC Flat Glass North America, Inc., Alpharetta, GA 30022-1167 (US); AGC Inc., Tokyo 100-8405 (JP); AGC Vidros do Brasil Ltda., CEP 12523-671 Guaratinguetá, São Paulo (BR); Panasonic Holdings Corporation, Osaka, 571-8501 (JP)
(72) Inventor: BEN TRAD, Abderrazek, 6041 Gosselies (BE); MAHIEU, Stijn, 6041 Gosselies (BE); ISHIBASHI, Tasuku, Osaka, 571-8501 (JP); URIU, Eiichi, Osaka, 571-8501 (JP); ABE, Hiroyuki, Osaka, 571-8501 (JP)
(74) Representative: AGC Glass Europe

(57) **Abstract**

The present invention concerns a coated glass pane comprising a glass substrate provided with a low-e coating wherein some layers comprise a noble gas, preferably argon and demonstrating a specific the releasable noble gas content per coated surface area of the coated glass pane. The present invention further concerns process to produce such coated glass panes and a vacuum insulating glazing comprising such coated glass pane.

## Description

### Technical Field

This invention relates to a glass sheet (or pane) coated with a magnetron sputtered coating, for example a low-e coating. The coated glass sheet of the invention is particularly suitable as part of a Vacuum Insulated Glazing Unit (VIG or vacuum IG). VIG are typically made of two glass sheets, wherein at least one of the glass sheet's major face that is oriented towards the internal space between the two glass sheets, is provided with a coating such as deposited by magnetron sputtering. The VIG may be used, for example, in building fenestration applications (windows and doors), vehicles, and fridge doors.

### Background Art

Vacuum Insulated glazing units have high thermal insulation ability, the expected thermal transmittance U being below 1.2 W / m²K. This performance is a direct consequence of the low thermal conduction in vacuum and thus depends on the quality of this vacuum and its stability.

Assembly of a VIG may be achieved through different known processes pursuing the same purpose of having a stable vacuum cavity formed in between two hermetically sealed glass panes, which are held apart with discrete spacers (or pillars). The vacuum cavity has a pressure level that is not greater than 0.1 mbar.

Different types of sealing material and different types of spacers are known in the art. Typical sealing means for VIGs are glass frits (also designated as solder glass) and metallic or ceramic solders. One of the most current sealing means is based on solder glass which has a melting point lower than that of the glass. The use of solder glass nevertheless limits the choice of low-e coatings to those that are not degraded by the thermal cycle required to apply the solder glass, i.e. to those that are able to withstand a temperature possibly as high as 250° C or even higher. Metal seals, for example soft tin-alloy solders or copper-based solders are an alternative and also have the advantage that they partially deform and thus partially absorb the differential expansions between the first and second panes when exposed to a temperature gradient across the thickness of the VIG.

In addition, an array of discrete spacers (or pillars) must be placed between the two glass panes in order to keep both panes at stable distance from each other. The discrete spacers can have different shapes, such as cylindrical, spherical, filiform, hourglass, C-shaped, cruciform, prismatic shape... It is preferred to use small pillars, i.e. pillars having in general a contact surface with the glass pane, delimited by its external circumference, equal to or lower than 5 mm², preferably equal to or lower than 3 mm², more preferably equal to or lower than 1 mm². These values may offer a good mechanical resistance whilst being aesthetically discrete.

The discrete spacers are typically made of a material which has sufficient strength to endure the pressure applied by the surfaces of the glass panes, which is capable of withstanding high-temperature processes such as burning and baking, and which emits little gas after the VIG has been sealed. Such a material is preferably a hard metal material, a quartz glass or a ceramic material. In particular, it may be a metal material such as iron, tungsten, nickel, chrome, titanium, molybdenum, carbon steel, chrome steel, nickel steel, stainless steel, nickel-chromium steel, manganese steel, chromium-manganese steel, chromium-molybdenum steel, silicon steel, nichrome, duralumin or the like, or it may be a ceramic material such as corundum, alumina, mullite, magnesia, yttria, aluminum nitride, silicon nitride or the like.

In order to maintain vacuum over time, a getter is placed in the VIG. Generally, such a getter is based on a metal alloy, as for example based on zirconium, iron, cobalt, and/or aluminium. The getter is placed in the form of a thin layer or in the form of a block, within the hermetically sealed space between the two glass panes. After its activation, the getter will absorb gases that are released during the life time of the VIG, to maintain the vacuum.

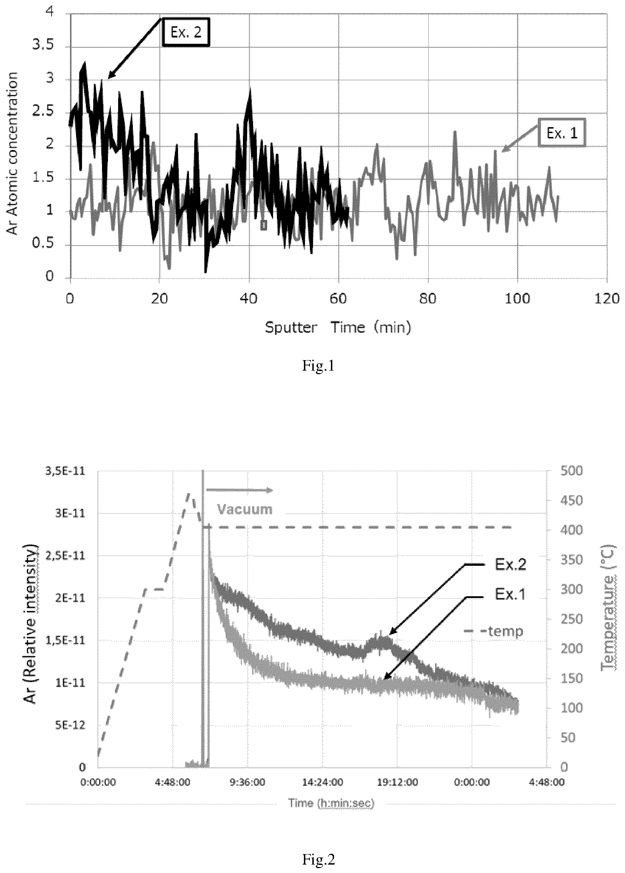

There are different processes for assembling a VIG. The assembly process described in EP2851351A1, whose content is hereby incorporated by reference in its entirety, comprises three main steps which may overlap. First, a first glass pane is placed horizontally, the glass frit is deposited, the pillars are placed and a second pane is disposed on top, a first heating period up to 450° C allows the hermetical sealing of both glass panes at their outer edges, leaving a space in between. The second step is the pumping of inside gases down to a residual pressure of not more than 0.1 mbar. With respect to the formation of the vacuum in the internal space of the glass unit, a hollow glass tube connecting the internal space to the outside is generally provided on the main face of one of the glass sheets. The vacuum is thus created in the internal space by pumping the gases present into the internal space by means of a pump connected to the outer end of the glass tube. The production method of EP2851351A1 indeed describes a method of making a vacuum insulating glazing comprising: (a) hermetically bonding, with a hermetically-bonding member, peripheries of paired glass panels disposed facing each other at a predetermined distance to form a space to be hermetically enclosed between the glass panels; (b) evacuating air from the space through an outlet to make the space be in a reduced-pressure state; and (c) dividing the space by a region forming member into an outlet region including the outlet and a reduced-pressure region other than the outlet region. The region forming member includes an air passage interconnecting the outlet region and the reduced-pressure region when the space is formed. After the space is made in the reduced-pressure state, the space is divided into the outlet region and the reduced-pressure region by closing the air passage; so that the ends of the region forming member are connected to the hermetically-bonding member to surround the outlet together with the hermetically-bonding member. The hermetically-bonding member and the region forming member are made by use of the same low-melting glass frit. EP 2 851 351A further refers to [0034] to [0054] describing a first production method for a VIG assembly as illustrated in figures 1 to 4 and 6, which as shown in figure 5 comprises a first melting process at a temperature of 450° C to hermetically bond the peripheries of the glass panels; an evacuation process wherein the temperature of the furnace is decreased below the melting point temperature of 434° C of the glass frit for vacuum creation; and a second melting process at 465° C finalise the air evacuation and closing of the evacuation hole. Within [0056] to [0079] and figure 7, is described a variation of the above production method wherein the temperature of the pane assembly is decreased down to room temperature after the first melting process.

EP1506945A1 for example describes the use of such a glass tube, which is welded in position in a through-hole provided in the main face of one of the glass sheets. During this second step, the temperature decreases in some extent and the glass panes come closer up to reaching the pillars which define the free space. The final space between the two glass panes is not greater than 2 mm. The third step comprises a second heating period up to 465° C, allowing the pillars to adhere to the glass panes and also finalizing the hermetic sealing. This technique impairs the aesthetic appearance of the glass panel as no visible protrusion on the surface of one of the glass sheet is formed.

Another possibility to further improve the insulating ability of a VIG is to use a solar control or a low-e coating on one or more faces of the glass panes used in the VIG assembly. Preferably, the solar-control or the low-e coating is deposited on a face of a glass pane which will be oriented towards the vacuum space of the VIG. Because of the high temperature sealing means and further possible treatments, it is necessary for the coating to be resistant to high temperature treatments. For example, US5657607A, discloses a low-e coating for VIGs but is silent about any compatibility of the low-e coating with the assembly conditions. A second example, US1001219B2, mentions ITO, tin oxide or thin metal layers as low-e coatings that are designed to be incorporated into a VIG unit, but the purpose of this patent is to perform the assembly of this VIG unit at a lower temperature. US1001219B2 gives no indication of vacuum stability in case of re-heating process after the VIG has been hermetically sealed.

The inventors observed that when performing a VIG assembly process similar to the ones described in EP2851351A1 to assemble two glass panes, one of which being coated with a low-e coating, some new unexpected problems emerged. Despite the fact that the targeted vacuum has been reached after having completed the final sealing step, the performance of the VIG unit was altered. The inventors surprisingly found that this problem is related to the presence of a noble gas being incorporated in the low-e coating and which is released after the VIG is sealed. This noble gas was found to stem from the deposition process of the low-e coating, providing a low-e coating that comprises a noble gas, generally argon. As a result, in particular for VIG, during the production process, it appears that after the vacuum pumping has been performed and the VIG assembly has been sealed, the high temperature still present is responsible for further gas release which impact the final residual pressure in the VIG unit and as a consequence impacts the VIG unit's thermal performance. It has been found that in such circumstances, there might be a release of noble gas during the production process and/or the life time of the glazing. Moreover in the case of noble gas, the getter placed inside the cavity of the vacuum insulating glazing, was found to be inefficient to trap it and maintaining the vacuum level.

This investigation shows the necessity to specify a maximum noble gas concentration allowed in a low-e coating deposited on a glass pane, in particular when designated to be used in a VIG assembly. At the same time Argon is indispensable for the sputtering deposition of certain materials and is often crucial for an efficient, economic process.

This also shows there is a need to define specific coating conditions to enable the sputtering deposition of a low-e coating which fulfils the above condition related to maximum noble gas concentration in the low-e coating and more particularly in the layers of a low-e coating other than the functional layer, i.e. the generally metallic radiation reflecting functional layer and the protecting barrier deposited on said functional layer.

### Summary of invention

The invention concerns a glass substrate (also referred to as glass sheet or glass pane) coated with a sputtered low-e coating characterised by a maximum noble gas concentration in the low-e coating. The coated glass sheet is such that noble gas release under specified vacuum conditions does not exceed a certain amount which is directly correlated to the total molar quantity of said noble gas released.

Therefore, in its first embodiment, the present invention relates to a coated glass pane wherein the low-e coating does not exceed the threshold amount of noble gas, in that it comprises a releasable noble gas content of the coated glass pane, at a pressure of less than 10⁻⁶ mbar and after heating from room temperature to 460° C in 100 minutes, maintaining at 460° C for 20 minutes, cooling from 460° C to 23° C in 100 minutes of less than 1.5 × 10⁻⁶ mbar.cm³ per mm² of coated surface area of the coated glass pane as measured by the "outgassing noble gas measurement" (ONGM) described later.

Therefore, in its first embodiment, the present invention relates to a coated glass pane comprising a glass substrate provided with a low-e coating comprising an alternating arrangement of n infrared radiation reflecting functional layers and n+1 dielectric coatings, with n ≥ 1,
- such that each infrared radiation reflecting functional layer is surrounded by dielectric coatings, the dielectric coating comprising one or more dielectric layers, and
- such that each infrared radiation reflecting functional layer is protected by a barrier layer directly above and contacting it,
wherein at least one layer other than each infrared radiation reflecting functional layer and the barrier layer, comprises a noble gas, preferably argon.

The low-e coating can further comprise a protective topcoat, optionally comprising one or more dielectric layers. The low-e coating can also further comprise a seeding layer, optionally comprising a dielectric layer, below and in contact with at least one infrared radiation reflecting functional layer.

In the low-e coating of the coated glass pane of the present invention, the at least one layer other than each infrared radiation reflecting functional layer and the barrier layer, is a dielectric layer from within the dielectric coating, the seeding layer and/or the protective topcoat. The total geometrical thickness of the dielectric layers deposited under noble gas-comprising atmosphere is at least 30 nm and not more than 120 nm.

The coated glass pane of the present invention is characterised by a releasable noble gas content per coated surface area of the coated glass pane, at a pressure of less than 10⁻⁶ mbar and after heating from room temperature to 460° C in 100 minutes, maintaining at 460° C for 20 minutes, cooling from 460° C to 23° C in 100 minutes is less than 1.5 × 10⁻⁶ mbar.cm³ per mm² of coated glass pane.

To reach this goal, the invention defines sputtering conditions to deposit a low-e coating on a glass pane allowing to fulfil the noble gas amount threshold above. Therefore, in one embodiment, the invention concerns a method for the production of a coated glass pane comprising: providing a glass substrate in a magnetron sputtering installation, depositing the layers on a glass substrate by cathodic sputtering at reduced pressure, wherein
i) only the infrared radiation reflecting functional layer(s) and the barrier layer(s) are deposited in an atmosphere containing between 95% and 100% of noble gas, preferably argon;
ii) metal oxide dielectric layers from metallic targets are deposited in an atmosphere containing between 95% and 100% of oxygen;
iii) other dielectric layers are deposited in an atmosphere such that the noble gas volume ratio in gas atmosphere is not greater than 90%.

In another embodiment, the invention also concerns means to remove the excess of noble gas present in a low-e coating before the coated glass sheet is assembled in a VIG unit and in such a way that the coated glass fulfils the noble gas amount threshold condition described above. The means of this embodiment comprises a process for the pre-baking of the low-e coated glass. Thereby the low-e coated glass respects the noble gas amount threshold condition, whatever its deposition conditions have been. During this process any excess of noble gas may be removed by performing heating of the coated glass, preferably under vacuum. In this embodiment, the coated glass pane is heat treated at a temperature greater than 300° C, preferably 400° C and more preferably 480° C.

The present invention further relates to coated glass panes that are obtained by any of the methods described above. The present invention also relates to the use of the coated glass pane to produce a vacuum insulating glazing and finally the present invention relates to a vacuum insulating glazing comprising such a coated glass pane.

### DETAILED DESCRIPTION

The present invention addresses the technical problem of providing and performing coated glass pane, in particular for use in a vacuum insulating glazing. Noble gas are recognised as cost effective and efficient deposition gas for use in a magnetron sputtering process, and therefore are commonly used in the production of coated glass panes. However, it has been surprisingly found that coated glass panes wherein one or more layers of the low-e coating has/have been deposited under noble gas, will not provide the required thermal performance when incorporated into a glazing assembly, in particular within a vacuum insulating glazing. Hence, the present invention is based on the limitation of the amount of noble gas release by such coated glass panes.

According to the present invention the low-e coating comprises at least one magnetron sputtered coating layer. In an embodiment of the present invention, the coated glass pane's low-e coating comprises: an alternating arrangement of n infrared radiation reflecting functional layers and n+1 dielectric coatings, with n ≥ 1, such that each infrared radiation reflecting functional layer is surrounded by dielectric coatings, the dielectric coatings comprising one or more layers of dielectric material, and such that each infrared radiation reflecting functional layer is protected by a barrier layer directly above and contacting it. n is a positive integer equal to or greater than 1 (n ≥ 1).

Preferably n is a positive integer equal to or lower than 3 (n ≤ 3), more preferably, n is equal to 1 or equal to 2. It has been found that such limited number of alternating arrangement(s) provide the right equilibrium between thermal performance of the glazing assembly that will incorporate the coated glass pane and the production costs of such coated glass pane.

As described herein, a dielectric coating is made of one or more layer(s) made of dielectric materials, that can be hereinafter referred to as "dielectric layer". The dielectric coating can also be referred to as "dielectric film". The coated glass pane can further comprise a protective topcoat that optionally comprises one or more dielectric layers; and/or a seeding layer optionally comprising a dielectric layer, below and in contact with at least one infrared radiation reflecting functional layer. The at least one layer other than each infrared radiation reflecting functional layer and the barrier layer may therefore be a dielectric layer originating from within the dielectric coating, the seeding layer and/or the protective topcoat.

Therefore, for n = 1, the low-e coating deposited on the glass substrate of the present invention is an alternating arrangement comprising at least - in the following order, starting from the surface of the glass substrate:
- a dielectric coating made of one or more dielectric layer(s);
- an infrared radiation reflecting functional layer;
- a barrier layer;
- a dielectric coating made of one or more dielectric layer(s).

Therefore, for n = 2, the low-e coating deposited on the glass substrate of the present invention is an alternating arrangement comprising at least - in the following order, starting from the surface of the glass substrate:
- a dielectric coating made of one or more dielectric layer(s);
- an infrared radiation reflecting functional layer;
- a barrier layer;
- a dielectric coating made of one or more dielectric layer(s);
- an infrared radiation reflecting functional layer;
- a barrier layer;
- a dielectric coating made of one or more dielectric layer(s).

In particular, according to an embodiment of the present invention, the low-e coating deposited on the glass substrate of the present invention is an alternating arrangement comprising at least - in the following order, starting from the surface of the glass substrate:
- a dielectric coating made of one or more dielectric layer(s); having a geometrical thickness comprised between 20 and 40 nm,
- an optional seeding layer, preferably comprising ZnO, having a geometrical thickness comprised between 2 and 10 nm,
- an infrared radiation reflecting functional layer; preferably comprising Ag, having a geometrical thickness comprised between 8 and 18 nm,
- a barrier layer; preferably comprising ZnO, having a geometrical thickness comprised between 1 nm to 12 nm, preferably from 2 nm to 8 nm,
- a dielectric coating made of one or more dielectric layer(s); having a geometrical thickness comprised between 40nm and 100 nm, preferably between 60 and 100nm,
- an optional seeding layer, preferably comprising ZnO; having a geometrical thickness comprised between 2 and 10 nm,
- an infrared radiation reflecting functional layer; preferably comprising Ag; having a geometrical thickness comprised between 8 and 18nm,
- a **barrier** layer; preferably comprising ZnO; having a geometrical thickness comprised between1 nm to 12 nm, preferably from 2 and 8 nm,
- a dielectric coating made of one or more dielectric layer(s); having a geometrical thickness comprised between 10 and 45 nm, and
- an optional protective topcoat comprising one or more dielectric layer(s) and having a thickness comprised between 1 and 10nm.

At least one layer other than each infrared radiation reflecting functional layer and the barrier layer, comprises a noble gas, preferably argon. This may for example be one layer of a dielectric coating, from the seeding layer and/or protective topcoat. Indeed, in an cost efficient industrial magnetron sputtering process as many layers as possible should be deposited in a noble gas comprising atmosphere.

It has been found that such when such layers are deposited under noble gas atmosphere, some noble gas is indeed trapped within the corresponding low-e coating. When such coated glass pane are used in a glazing assembly which production process requires high temperature, the noble gas may diffuse through the coating and be released.

In the coated glass pane of the present invention the releasable noble gas content per coated surface area of the coated glass pane, at a pressure of less than 10⁻⁶ mbar and after heating from room temperature to 460° C in 100 minutes, maintaining at 460° C for 20 minutes, cooling from 460° C to 23° C in 100 minutes is less than 1.5 × 10⁻⁶ mbar.cm³ per mm² of coated glass pane.

In one embodiment of the invention the releasable noble gas content per coated surface area of the coated glass pane, at a pressure of less than 10⁻⁶ mbar and after heating from room temperature to 460° C in 100 minutes, maintaining at 460° C for 20 minutes, cooling from 460° C to 23° C in 100 minutes is less than 1.0 × 10⁻⁶ mbar.cm³ per mm² of coated glass pane, preferably is less than 0.5 × 10⁻⁶ mbar.cm³ per mm² of coated glass pane.

In another embodiment, the total geometrical thickness of the dielectric layers deposited in a noble gas-comprising atmosphere, of the coated glass pane of the invention, is at least 35 nm, alternately at least 40 nm, alternately at least 45 nm, and alternately at least 60 nm. In another embodiment, the total geometrical thickness of dielectric layer deposited in an atmosphere including argon is not more than 100 nm and more preferably not more 90 nm.

Therefore, the total geometrical thickness (TGT) of the dielectric layer(s) that is/are deposited in an atmosphere comprising a noble gas, in particular argon, is comprised between 30 nm and 120 nm (30 nm ≥ TGT ≥ 120 nm). In a preferred embodiment of the present invention, the total geometrical thickness (TGT) of the dielectric layer(s) that is/are deposited in an atmosphere comprising a noble gas is comprised between 35 nm and 120nm (35 nm ≥ TGT ≥ 120 nm), preferably between 40 nm and 100 nm (40 nm ≥ TGT ≥ 100 nm) and more preferably between 45 nm and 100 nm (45 nm ≥ TGT ≥ 100 nm) and most preferably between 60 nm and 90 nm (60 nm ≥ TGT ≥ 90 nm). It has been found that such limited thickness of the dielectric layers deposited in an atmosphere comprising a noble gas, in particular argon; provides the right equilibrium between performance of the glazing assembly that will incorporate the coated glass pane and the production costs of such coated glass pane.

In another embodiment of the invention, the infrared radiation reflecting functional layer(s) of the low-e coating comprise silver or consist of silver. In another preferred embodiment of the present invention, the geometrical thickness of the infrared radiation reflecting functional layer(s) of the low-e coating, preferably comprising Ag, is between 8 and 18 nm, preferably between 8 and 16 nm and most preferably between 10 and 14 nm.

In another preferred embodiment of the present invention, the last dielectric layer of the last dielectric coating of the low-e coating comprises a noble gas, preferably argon and has a geometrical thickness comprised between 1 and 30 nm, preferably from 10 nm to 30 nm, more preferably from 20 nm to 30nm.

In another embodiment of the invention, the coated glass pane comprises from the glass substrate outwardly a) a tin zinc oxide layer; b) a zinc oxide based layer ; c) a silver layer; d) a barrier layer; e) a dielectric film (dielectric coating). In this embodiment, the positive integer n therefore equals to 1 (n = 1).

In another embodiment of the invention, the coated glass pane comprises from the glass substrate outwardly a) a tin zinc oxide layer; b) a zinc oxide based layer ; c) a silver layer; d) a barrier layer; e) a dielectric film (dielectric coating) f) a zinc oxide based layer; g) a second silver layer; h) a barrier layer; i) a dielectric film (dielectric coating). In this embodiment, the positive integer n equals therefore to 2 (n = 2).

In another embodiment of the invention, the barrier layer of the low-e coating comprises a metal or metal alloy, and/or an oxide and/or a nitride of this metal or metal alloy. The metal or metal alloy may be chosen from the list consisting of titanium, zinc, nickel, chromium, niobium and any alloy including one of these metals. More particularly, the barrier is a zinc oxide based barrier, in particular an aluminium doped zinc oxide layer or an essentially pure zinc oxide layer.

In another embodiment of the invention, the dielectric film or dielectric coating comprises a single layer or multiple dielectric layers comprising any of the oxides or nitrides of titanium, silicon, zinc, tin, zirconium or mixtures thereof.

In another embodiment of the invention, a protective topcoat can be provided over the low-e stack. The protective topcoat is indeed the last layer of the low-e coating, furthest away from the substrate surface. The protective topcoat provides further mechanical and/or chemical protection function(s) to the low-e coating. The protective topcoat may comprise one or more layers, selected from the group consisting of any typical dielectric layers, metallic layers and eventually can be combined with a carbon layer or temporary protective layer that disappears during heating.

When present and in the form of a typical dielectric layer or metallic layer, the thickness of such a protective topcoat is to be taken into account when calculating the total geometrical thickness of the dielectric layers deposited in a noble gas-comprising atmosphere.

In another aspect of the invention, the coated glass pane of the invention is produced according a method comprising the following steps: providing a glass substrate in a magnetron sputtering installation, depositing the layers on a glass substrate by magnetron sputtering at reduced pressure, and deposition conditions are characterised in that
i) only the infrared radiation reflecting metal layer(s) and the barrier layer(s) are deposited in an atmosphere containing between 95% and 100% of noble gas, preferably argon;
ii) metal oxide dielectric layer(s) deposited from metallic targets are deposited in an atmosphere containing between 95% and 100% of oxygen;
iii) other dielectric layers are deposited in an atmosphere such that the noble gas volume ratio in the gas atmosphere is not greater than 90%.

In other words, only the infrared radiation reflecting functional layer(s) and the barrier layer(s) are deposited in an atmosphere containing between 95% and 100% of noble gas, preferably argon. The dielectric layers:
a) from metallic targets are deposited in an atmosphere containing between 95% and 100% of oxygen if they are metal oxide layers; and
b) are deposited in an atmosphere such that the noble gas volume ratio in gas atmosphere is not greater than 90% if they are not metal oxide layers.

Therefore, within such production method: The infrared reflecting metal layer(s)and the barrier layer(s) are deposited in an atmosphere comprising a volume ratio of 95% to 100% of noble gas, preferably argon. This means that the volume of noble gas, preferably argon, over the volume of total gas atmosphere, is comprised between 95% to 100% (95% ≤ [noble gas volume / total gas atmosphere volume] ≤100%). Preferably, the volume ratio of noble gas is comprised between 97% and 100%, is preferably 100% noble gas. A very limited amount of oxygen and/or nitrogen is accepted.

Within the dielectric coating, the metal oxide dielectric layer(s) that is/are sputtered from a metallic target, are specifically deposited in an atmosphere comprising a volume ratio of from 95% to 100% of oxygen, preferably is 100% oxygen. This means that the volume of oxygen over the volume of total gas atmosphere is comprised between 95% to 100% (95% ≤ [oxygen volume / total gas atmosphere volume] ≤ 100%).

The other layer(s) that can be encompassed within the dielectric coating(s) and which are not metal oxide dielectric layer(s) created from a metallic target, are deposited in an atmosphere comprising a volume ratio of noble gas in the total gas atmosphere being not greater than 90%. This means that the volume of noble gas, preferably argon, over the volume of total gas atmosphere is equal to or lower than 90% ( [noble gas volume / total gas atmosphere volume] ≤ 90%).

It has been surprisingly found that when such deposition conditions are met, the low-e coating provided on the glass substrate to form the coated glass pane of the present invention is such that the releasable noble gas content per coated surface area of the coated glass pane, at a pressure of less than 10⁻⁶ mbar and after heating from room temperature to 460° C in 100 minutes, maintaining at 460° C for 20 minutes, cooling from 460° C to 23° C in 100 minutes is less than 1.5 × 10⁻⁶ mbar.cm³ per mm² of coated glass pane. The present invention therefore encompasses a coated glass pane that has been produced by such method. In particular, the present invention further relates to a coated glass pane comprising a glass substrate provided with a low-e coating wherein such low-e coating comprises:
a) an alternating arrangement of n infrared radiation reflecting functional layers and n+1 dielectric coatings, with n ≥ 1,
   a. such that each infrared radiation reflecting functional layer is surrounded by dielectric coatings, the dielectric coating comprising one or more dielectric layers, and
   b. such that each infrared radiation reflecting functional layer is protected by a barrier layer directly above and contacting it,
   wherein at least one layer other than each infrared radiation reflecting functional layer and the barrier layer comprises a noble gas, preferably argon,
b) optionally, a protective topcoat, optionally comprising one or more dielectric layers;
c) optionally a seeding layer, optionally comprising a dielectric layer, below and in contact with at least one infrared radiation reflecting functional layer;

wherein the at least one layer other than each infrared radiation reflecting functional layer and the barrier layer, is a dielectric layer from within the dielectric coating, the seeding layer and/or the protective topcoat and wherein the total geometrical thickness of the dielectric layers deposited under noble gas-comprising atmosphere is at least 30 nm and not more than 120 nm; and
wherein the releasable noble gas content per coated surface area of the coated glass pane, at a pressure of less than 10⁻⁶ mbar and after heating from room temperature to 460° C in 100 minutes, maintaining at 460° C for 20 minutes, cooling from 460° C to 23° C in 100 minutes is less than 1.5 × 10⁻⁶ mbar.cm³ per mm² of coated glass pane;
and wherein such coated glass pane is produced by a method comprising the steps of providing a glass substrate in a magnetron sputtering installation and depositing the layers on a glass substrate by magnetron sputtering at reduced pressure, wherein the deposition conditions are the following:
   1) only the infrared reflecting metal layer and the barrier layer are deposited in an atmosphere containing between 95% and 100% of noble gas, preferably argon;
   2) metal oxide dielectric layers deposited from metallic targets are deposited in an atmosphere containing between 95% and 100% of oxygen;
   3) other dielectric layers are deposited in an atmosphere such that the noble gas volume ratio in the gas atmosphere is not greater than 90%.

In a preferred embodiment, the present invention encompasses a coated glass pane that has been produced by such method wherein the total geometrical thickness of the layers deposited in a noble gas-comprising atmosphere, is comprised between 35 nm and 120nm (35 nm ≥ TGT ≥ 120 nm), more preferably between 40 nm and 100 nm (40 nm ≥ TGT ≥ 100 nm) and most preferably between 45 nm and 100 nm (45 nm ≥ TGT ≥ 100 nm) and even more preferably between 60 nm and 90 nm (60 nm ≥ TGT ≥ 90 nm).

In a preferred embodiment, the present invention further relates to the coated glass pane described above wherein the last layer of the low-e coating, preferably the last dielectric layer of the last dielectric coating, is deposited under a gas atmosphere comprising from 1 to 50%, preferably from 1% to 45%, more preferably from 5% to 40% of noble gas, preferably argon. This means that the volume of noble gas over the volume of total gas atmosphere is comprised between 1% to 50% (1% ≤ [noble gas volume / total gas atmosphere volume] ≤ 50%), preferably 1% to 45% (1% ≤ [noble gas volume / total gas atmosphere volume] ≤ 45%), more preferably from 5% to 40% (5% ≤ [noble gas volume / total gas atmosphere volume] ≤ 40%).

In another aspect of the invention, the coated glass pane of the invention is produced according a method comprising in sequence: providing a glass substrate in a magnetron sputtering installation, depositing the layers on a glass substrate by magnetron sputtering at reduced pressure, heat treating at a temperature greater than 300° C, preferably 400° C and more preferably 480° C. Such process can be referred to as baking process.

Alternatively heat treating may be performed at a pressure below 1 bar, preferably equal to or below 10 mbar, more preferably equal to or below 1 mbar and most preferably equal to or below 0.1 mbar. Heat treating may be performed by holding the temperature during a time which is at least 0.5 hour, preferably at least 2 hours and more preferably at least 6 hours, depending the operating temperature and pressure.

The present invention therefore encompasses a coated glass pane that has been produced by such method. In particular, the present invention also relates to a coated glass pane comprising a glass substrate provided with a low-e coating wherein such low-e coating comprises:
a) an alternating arrangement of n infrared radiation reflecting functional layers and n+1 dielectric coatings, with n ≥ 1,
   - such that each infrared radiation reflecting functional layer is surrounded by dielectric coatings, the dielectric coating comprising one or more dielectric layers, and
   - such that each infrared radiation reflecting functional layer is protected by a barrier layer directly above and contacting it,
   wherein at least one layer other than each infrared radiation reflecting functional layer and the barrier layer comprises a noble gas, preferably argon,
b) optionally, a protective topcoat, optionally comprising one or more dielectric layers;
c) optionally a seeding layer, optionally comprising a dielectric layer, below and in contact with at least one infrared radiation reflecting functional layer;

wherein the at least one layer other than each infrared radiation reflecting functional layer and the barrier layer, is a dielectric layer from within the dielectric coating, the seeding layer and/or the protective topcoat and wherein the total geometrical thickness of the dielectric layers deposited under noble gas-comprising atmosphere is at least 30 nm and not more than 120 nm; and
wherein the releasable noble gas content per coated surface area of the coated glass pane, at a pressure of less than 10⁻⁶ mbar and after heating from room temperature to 460° C in 100 minutes, maintaining at 460° C for 20 minutes, cooling from 460° C to 23° C in 100 minutes is less than 1.5 × 10⁻⁶ mbar.cm³ per mm² of coated glass pane; wherein such coated glass pane is produced by a method comprising, in sequence, the following steps of :
   - providing a glass substrate in a magnetron sputtering installation,
   - depositing layers on a glass substrate by magnetron sputtering at reduced pressure, and
   - heat treating at a temperature greater than 300° C (Temp > 300° C), preferably greater than 400° C (Temp > 400° C) and more preferably greater than 480° C (Temp > 480° C).

In a preferred embodiment, the present invention encompasses a coated glass pane that has been produced by such method wherein the total geometrical thickness of the layers deposited in a noble gas-comprising atmosphere, is comprised between 35 nm and 120nm (35 nm ≥ TGT ≥ 120 nm), more preferably between 40 nm and 100 nm (40 nm ≥ TGT ≥ 100 nm) and most preferably between 45 nm and 100 nm (45 nm ≥ TGT ≥ 100 nm) and even more preferably between 60 nm and 90 nm (60 nm ≥ TGT ≥ 90 nm).

In such methods, the heat treating step may be performed at a pressure below 1 bar, preferably below 10 mbar, more preferably below 1 mbar and most preferably below 0.1 mbar. In such methods, the heat treating step may be performed by maintaining the temperature for a time of at least 0.5 hour, preferably at least 2 hours and more preferably at least 6 hours, depending on the operating temperature and pressure.

In one embodiment of the present invention, the deposition conditions of the specific sputtering process can be combined with the heating step of the baking process to produce the coated glass pane of the present invention.

In another aspect of the invention, the coated glass pane is used as part of a vacuum insulated glazing, the low-e coating facing the vacuum space of the VIG unit. Therefore, the present invention encompasses a vacuum insulating glazing comprising a coated glass pane comprising a glass substrate provided with a low-e coating wherein such low-e coating comprises:
a) an alternating arrangement of n infrared radiation reflecting functional layers and n+1 dielectric coatings, with n ≥ 1,
   - such that each infrared radiation reflecting functional layer is surrounded by dielectric coatings, the dielectric coating comprising one or more dielectric layers, and
   - such that each infrared radiation reflecting functional layer is protected by a barrier layer directly above and contacting it,
   wherein at least one layer other than each infrared radiation reflecting functional layer and the barrier layer comprises a noble gas, preferably argon,
b) optionally, a protective topcoat, optionally comprising one or more dielectric layers;
c) optionally a seeding layer, optionally comprising a dielectric layer, below and in contact with at least one infrared radiation reflecting functional layer;

wherein the at least one layer other than each infrared radiation reflecting functional layer and the barrier layer, is a dielectric layer from within the dielectric coating, the seeding layer and/or the protective topcoat and wherein the total geometrical thickness of the dielectric layers deposited under noble gas-comprising atmosphere is at least 30 nm and not more than 120 nm; and
wherein the releasable noble gas content per coated surface area of the coated glass pane, at a pressure of less than 10⁻⁶ mbar and after heating from room temperature to 460° C in 100 minutes, maintaining at 460° C for 20 minutes, cooling from 460° C to 23° C in 100 minutes is less than 1.5 × 10⁻⁶ mbar.cm³ per mm² of coated glass pane.

In an aspect of the invention, a vacuum insulated glazing unit incorporating at least one coated glass pane of the invention is characterised by a U value not greater of 1.00 W/m²K, more preferably not greater than 0.90 W/m²K and most preferably 0.80 W/m²K.

Indeed assembly of the VIG unit incorporating a coated glass pane of the invention will allow a good vacuum to be reached despite high temperature required for the final sealing of the vacuum space. Moreover thanks to the coated glass pane of the invention, a good vacuum stability is obtained in the VIG whatever further operations or exposures may be. The VIG incorporating the coated glass pane of the invention is capable of surviving harsh environments, e.g., those typically characterized by high operational temperatures, as well as exposure to shocks and vibrations, humidity, contaminants, radiation, and/or the like. For example, in skylights, glazing systems are subjected to extreme temperatures (150 ° C) and shocks and vibration loading related to wind loads.

The present invention further relates to the use of a coated glass pane comprising a glass substrate provided with a low-e coating comprising:
a) an alternating arrangement of n infrared radiation reflecting functional layers and n+1 dielectric coatings, with n ≥ 1,
   - such that each infrared radiation reflecting functional layer is surrounded by dielectric coatings, the dielectric coating comprising one or more dielectric layers, and
   - such that each infrared radiation reflecting functional layer is protected by a barrier layer directly above and contacting it,
   wherein at least one layer other than each infrared radiation reflecting functional layer and the barrier layer comprises a noble gas, preferably argon,
b) optionally, a protective topcoat, optionally comprising one or more dielectric layers;
c) optionally a seeding layer, optionally comprising a dielectric layer, below and in contact with at least one infrared radiation reflecting functional layer;

wherein the at least one layer other than each infrared radiation reflecting functional layer and the barrier layer, is a dielectric layer from within the dielectric coating, the seeding layer and/or the protective topcoat and wherein the total geometrical thickness of the dielectric layers deposited under noble gas-comprising atmosphere is at least 30 nm and not more than 120 nm; and
wherein the releasable noble gas content per coated surface area of the coated glass pane, at a pressure of less than 10⁻⁶ mbar and after heating from room temperature to 460° C in 100 minutes, maintaining at 460° C for 20 minutes, cooling from 460° C to 23° C in 100 minutes is less than 1.5 × 10⁻⁶ mbar.cm³ per mm² of coated glass pane; within a vacuum insulating glazing.

Many low-e coatings are known in the art. The choice of such a coating depends on a compromise of many properties such as the emissivity, the light transmission and / or reflection, the aesthetics (colour, haze···), the resistance to heat treatments, the mechanical resistance, the durability.

The coated glass pane of the invention must satisfy the thermal, optical and aesthetic specifications expected in the final product. The person skilled in the art knows how to produce the desired low-e coating having desired optical and thermal properties. The invention brings now a solution to make those low-e coatings adjusted in such a way that they are convenient to be used in a VIG assembly.

When the coated glass pane of the invention is used as part of a VIG unit, said unit incorporating the coated glass pane of the invention proves to be highly performant in term of insulating capabilities. Indeed, it has been found that the superior thermal performance of the vacuum insulating glazing comprising the coated glass pane of the present invention can be maintained over the life time of the vacuum insulating glazing, despites the though production conditions and/or harsh environment conditions. It has been further found that the coated glass pane of the present invention provides a very interesting balance between thermal performance and cost of production. The objectives in term of performance for the VIG, being expressed in thermal transmittance U value and the contribution of the low-e coating with its emissivity, ε, are summarized in the table 1.

**Table 1. Properties of a VIG unit incorporated the coated glass pane of the invention**

| | preferably | More preferably | Most preferably |
|---|---|---|---|
| Thermal Transmittance U (W/m²K) | 1.00 | 0.90 | 0.80 |
| Emissivity ε | 0.07 | 0.05 | 0.03 |

In another aspect of the invention, the VIG unit may be part of a more complex insulating glazing unit (IGU) as for example a triple glazing unit with one or both internal spaces between the glass panes having a low pressure. This more complex glazing unit may have 2 or more glass panes and may incorporate non glass pane element as for example polymer film. The IGU may have more than one coated faces with the low-e of the invention or may have other type of coatings.

The glass substrate of the coated glass panes of present invention may be chosen among clear float glass, extra-clear float glass or coloured glass. The term "glass" is herein understood to mean any type of glass or equivalent transparent material, such as a mineral glass or an organic glass. The mineral glasses used may be one or more known types of glass such as soda-lime-silica, aluminosilicate or borosilicate, crystalline and polycrystalline glasses. The glass panes can be obtained by a floating process, a drawing process, a rolling process or any other process known to manufacture a glass pane starting from a molten glass composition. The glass panes can optionally be edge-ground. Edge grinding renders sharp edges into smooth edges which are much safer for people who could come in contact with the vacuum-insulating glazing unit, in particular with the edge of the glazing. Preferably, the glass panes according to the invention are of soda-lime-silica glass, aluminosilicate glass or borosilicate glass. Preferably, for reasons of lower production costs, the glass panes are panes of soda-lime-silica glass. Typically, the glass panes of the present invention are annealed glass panes.

It is noted that the invention relates to all possible combinations of features, embodiments and aspects recited in the description above and in the claims.

These and other features and advantages may be better and more completely understood by reference to the following detailed description of exemplary illustrative embodiments in conjunction with the drawings.

### Brief description of drawings

Fig.1 is a graphic representation of argon concentration in exemplified low-e stacks corresponding to Ex.1 and Ex.2.
Fig.2 is a qualitative graphical representation of argon release in vacuum under heating conditions as a function of time for the exemplified low-e stacks corresponding to Ex.1 and Ex.2.
Fig.3 is a cross-sectional view of a conventional vacuum insulating glazing unit.

### Description of embodiments

Definitions: To stay consistent, once an example has been defined and numbered (e.g. Ex.1), the number will remain attached to the same example (same low-e coating) in all paragraphs and tables. Room temperature is to be understood as a temperature of 23° . The thermal transmittance U is determined according to ISO 19916-1 and is expressed in W/m²K. The emissivity ε is measured according the EN 12898.

Within the present text, the low-e coating can also be referred to as low-e stack, layers stack or stack. Within the present text, the internal vacuum volume, defined by the first and second glass panes and the set of discrete spacers and closed by the hermetically bonding seal and wherein there is an absolute vacuum of pressure of less than 0.1 mbar is referred to as vacuum space or low-pressure space/gap or evacuated low-pressure space/cavity.Residual gases in the VIG have been analysed through Residual Gas Analysis (RGA). The RGA analyser is a system which allows to extract the gases contained inside the VIG and through a high sensitive quadrupole mass spectrometer, measures their partial pressures. This method is described by N.Ng, R.E.Collins and L.So in Journal of Vacuum Science & Technology A 21, 1776 (2003).

Argon presence in the different layers of the low-e stacks has been determined with help of X-ray Photoelectron Spectroscopy (XPS) and X-ray fluorescence spectrometry (XRF). These techniques give an image of the elements present in a coating directly correlated with the depth in the coating.

In a general manner, solar control coatings absorb and/or reflect at least certain wavelength ranges and generally will result in modifications of the opto-energetical properties of the glazing. The materials that make up the individual layers of such a coating are chosen depending on the desired final properties of the coated glass pane and comprise typically dielectric layers such as oxides, nitrides, carbides, oxy-nitrides, oxy-carbides, oxycarbonitrides, of metals or silicon, or of mixtures of at least two metals or a metal and silicon.

Frequently used in these dielectric layers is silicium and/or metals such as titanium, zirconium, bismuth, niobium, tin, zinc. The coatings also comprise typically metallic layers, comprising for example silver, nickel, chromium, tungsten, gold, palladium, titanium or mixtures thereof.

More particularly, a low-e coating is to be understood here as any stack of thin layers sputtered on a glass substrate and comprising at least one infrared radiation reflecting functional layer as for example, silver, gold, palladium or any metal which is capable of reflecting infrared radiation, said functional layer being surrounded by dielectric coatings.

By dielectric layer, one should understand an oxide, nitride, oxinitride of silicon and/or a metal selected from titanium, zinc, tin, zirconium··· and mixture or alloy thereof. Indeed, a dielectric layer is sometimes a mixture of metal oxides. For example, a tin zinc oxide can comprise zinc and tin in proportions of 10 wt.% to 90 wt.% zinc and 90 wt.% to 10 wt.% tin. Some layers may be doped to form transparent conductive oxides, for instance fluorine doped tin oxide, indium tin oxide, or zinc oxide doped with aluminium, gallium, or boron. Silicon oxide or nitride may content up to 10 wt % of Aluminium. Zinc oxide is to be understood as an oxide based on zinc as metal, but this oxide is often doped with another metal, as for example, aluminium.

In a more general manner, the low-e coating of the invention comprises a first dielectric coating comprising tin zinc oxide layer with a thickness not smaller than 8 nm, preferably 10 nm, more preferably 12 nm and not greater than 45 nm, preferably 30 nm, more preferably 20 nm. The first dielectric coating may also comprise a titanium oxide, a zirconium oxide or a mixture thereof with a thickness which is not smaller than 8 nm, preferably 10 nm, more preferably 12 nm and not greater than 45 nm, preferably 35 nm, more preferably 25 nm. Above the first dielectric and directly below the silver layer, a seeding layer can be deposited. This layer has further multiple purposes such as improving adhesion of the silver layer, improving quality of the silver layer by decreasing its emissivity and also protecting the silver layer. This seeding layer is advantageously a zinc oxide based layer. By a zinc oxide based layer, one should understand that the zinc oxide may include other doping metallic element as for example aluminium. When present and in the form of a dielectric layer, the thickness of such seeding layer is to be taken into account when calculating the total geometrical thickness of the dielectric layers deposited in a noble gas-comprising atmosphere.

Above the silver layer, a protecting barrier layer is deposited. Preferably but not in a limiting way, this barrier layer is a zinc oxide doped with aluminium and is depositing in known way from a ceramic target under an 100% argon atmosphere in order to avoid contamination of the silver layer with oxygen. Alternatively, the barrier layer may be a metal selected from titanium, nickel, chromium or alloy including one of them. The barrier layer has a thickness not smaller than 1 nm, preferably not smaller than 2 nm, more preferably not smaller than 3 nm and not greater than 12 nm, preferably not greater than 10 nm, more preferably not greater than 9 nm. The last dielectric coating, above the last silver layer is advantageously a multiple layers coating. The multiple layers coating of the last dielectric coating advantageously comprises one or more of the following layers: a zinc oxide based layer, a tin zinc oxide layer, a silicon nitride layer, a titanium zirconium oxide layer, a titanium oxide layer.

General modern magnetron sputtering methods are well-known in the art and the skilled man perfectly knows how to deal with. Namely the process comprise sputtering a target with an ionized gas selected from argon, krypton, helium, carbon dioxide. The gas may also comprise, or consist of, oxygen or nitrogen as reactive gases if the layer to deposit is an oxide or a nitride. Atmosphere is preferably pure argon when it is necessary to avoid degradation of a metallic layer, as for example, a silver layer or the barrier layer which protect the silver. Choosing argon is due to the fact that it is inert, has sufficient mass, and is not too expensive. However, in one aspect, the present invention is directed to a coated glass pane wherein the typical gas atmosphere sputtering conditions have been carefully designed so as to create a low-e coating deposited on a glass substrate in such a manner that the releasable noble gas content per coated surface area of the obtained coated glass pane, at a pressure of less than 10⁻⁶ mbar and after heating from room temperature to 460° C in 100 minutes, maintaining at 460° C for 20 minutes, and cooling from 460° C to 23° C in 100 minutes is less than 1.5 × 10⁻⁶ mbar.cm³ per mm² of coated glass pane.

The low-e coating of the present invention is designed to have specific properties in terms of thermal performances, durability, aesthetic optical characteristics and to fulfil the VIGs' durability requirements. In some embodiments, the low-e coatings are also expected to be heat treatable, which means that they are capable of being heat treated to temperature as high as 650° C without degradation of their properties.

As examples and by no way limiting the invention, some coated glass panes with low-e coatings have been prepared. Table 2 gives the structure of those low-e stacks. As will be discussed later, the Ex.2 is a counter-example of the invention.

**Table 2: low-e coatings used as examples with thicknesses expressed in nm given in brackets**

| Ref | Stack description |
|---|---|
| Ex.1 | ZSO5 (37) / ZnO:Al (5) / Ag (13) / Ti (2) / ZSO5 (45) / ZnO (12) / Ag (13) / Ti (2) / ZSO5 (28) / TiO₂ (1) |
| Ex.2 Comparative example | ZSO5 (13) / TZO (21) / ZnO:Al (6) / Ag (10) / AZO (7) / ZSO5 (11) / SiN (24) / TZO (6) |

**ZSO5** means a zinc-tin oxide layer having a zinc/tin proportion with 52.4 wt % of zinc. According to embodiments of the present invention zinc tin oxides may have zinc/tin weight ratios in the range from 90/10 to 10/90. **ZnO:AI** is an aluminium doped zinc oxide deposited from a doped zinc metallic cathode in a reactive sputtering oxygen atmosphere. **AZO** is an aluminium doped zinc oxide deposited from a ceramic cathode in an inert atmosphere. Independent of the deposition method, aluminium doped zinc oxide layers may have an aluminium doping percentage comprised between 2 and 10 at%. **SiN** is a silicon nitride deposited from a silicon cathode which is preferably doped with aluminium. **TZO** is a mixed layer of TiO₂ and ZrO₂ oxide in a TiO₂/ZrO₂ weight ratio of 65/35. According to embodiments of the present invention titanium zirconium oxides may have TiO₂/ZrO₂ weight ratios in the range from 90/10 to 50/50. Ag is a layer of the silver metal deposited from a Ag metal cathode and Ti a layer of the titanium metal deposited from a metal Ti cathode . TiO₂ is a layer of titanium dioxide deposited from a metal Ti cathode.

Each coated glass panes described in Table 2 have been assembled in a VIG assembly, with the coated surface facing the interior of the vacuum unit. Respective VIG units are named VIG ex.1 and VIG ex.2 and are made respectively with one coated glass pane having the low-e coatings described in Ex.1 and Ex.2.

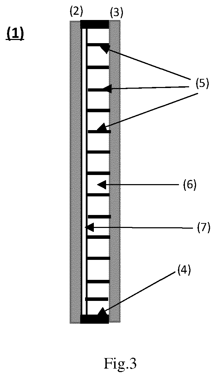

The exemplified VIG unit (1) of Fig.3 includes two spaced apart substantially parallel glass substrates (2), (3) hermetically sealed together in such a way to enclose an evacuated low-pressure space/cavity (6) there between. Glass panes or substrates (2), (3) are interconnected by a peripheral edge seal (4) and an array of support pillars/spacers (5) are included between the glass substrates (2), (3) to maintain the spacing of substrates (2), (3) of the VIG unit (1) in view of the low-pressure space/gap (6) present between the substrates (2), (3). The low-e coating of the invention (7) is present to the inner part of the vacuum insulated glazing unit. For clarity, the VIG unit of figure 3 is not scaled to reality.

After assembly of the VIG with the coated glass pane of the examples 1 and 2, performances of the VIG obtained have been asserted through measurement of the thermal transmittance and emissivity properties. Results are given in Table 3.

**Table 3 Thermal performance of VIG**

| | VIG ex.1 | VIG ex.2 |
|---|---|---|
| | Within the invention | Comparative example |
| U (W/m²K) | 0.76 | 1.5 |
| Emissivity ε | 0.02 | 0.032 |

Table 3 shows a great difference between both low-e coatings in terms of thermal performance. The VIG assembled with a coated glass pane (VIG Ex.1) demonstrates a much lower thermal transmittance (U = 0.76 W/m²K) than the comparative example (VIG ex.2) that demonstrates a higher thermal transmittance (U = 1.5 W/m²K)., Both VIG units have been submitted to a second analyse: The residual gases inside the units have been pumped out and analysed through the RGA method. The results of this analysis are given in table 4. The gases concentration are given as ratio in the total amount of gases, i.e. the volume of the specific gas over the volume of total gas atmosphere.

**Table 4 Analyse of the gases through the RGA method in the VIG assembly**

| gas | VIG ex.1 Conc (%) | VIG ex.2 - Comparative exemple Conc (%) |
|---|---|---|
| He | 0.49 | 0.13 |
| N₂ | 82.51 | 31.19 |
| CH₄ | 1.78 | 0.68 |
| CₙHₘ | <0.01 | 0.04 |
| Ar | 15.21 | 67.97 |

Being lower than 0.5%, the volume ratio of helium is not significant. What immediately appears from the table 4 is the huge amount of argon that has been found in the residual gases present in the vacuum space of the VIG unit of the comparative example VIG ex.2, after it has been closed. It has been found that that this huge amount of argon could only be originated from the low-e coating deposited on the glass surface.

In the VIG ex.1, the amount of the noble gas, in majority argon, within the released gas composition is much lower, i.e. 15.21% than in the comparative example VIG ex.2 wherein the amount of argon reaches 67.97%. In VIG ex.1, the gas composition is dominated by nitrogen which is released from the getter under the conditions of the Residual Gas Analysis (RGA) analysis. Nitrogen is not an issue for the insulation performance of the VIG since this gas is trapped by the getter. Therefore, the nitrogen detected during the RGA analysis is not taken into consideration.

Deposition of low-e coating on the glass substrate under noble gas, preferably argon, is highly recommended for efficiency and cost production reasons. The present invention is therefore based on the surprising technical finding that it is critical for the sustainability and thermal performance of a glazing, in particular a VIG, that encompasses at least one coated glass pane wherein the coating is facing the interior of the glazing and wherein such coating comprise layers that have been deposited under a noble gas atmosphere; that such amount of noble gas is carefully limited so as to avoid excessive release during the production of the glazing and/or over time. Indeed, it has been found that noble gas can be entrapped within the coating during sputtering and later diffuse through the coating at high temperatures and therefore be released inside the glazing, in particular, inside the vacuum space. It has been further found that not only some low-e coating present a higher amount of argon entrapped but as well as the diffusion kinetics of noble gas through the low-e coating is highly dependent of the temperature. Therefore, in one embodiment, the present invention relates to method to deposit a low-e coating on a glass substrate wherein the deposition conditions has been specifically designed to limit the amount of noble gas release inside the glazing, in particular the vacuum space, when such coated glass pane is assembled into a glazing, in particular a VIG. In another embodiment, the present invention relates to coated glass pane which has been heat treated at a temperature above 300° C before being assembled into a glazing.

Tables 5 (a) and (b) below give the stack composition and thicknesses of the low-e coating deposited outwardly from the glass substrate for examples 1 and 2 as well as the noble gas concentration, argon, present during the sputtering deposition of the different layers.

In all tables below, the infrared radiation reflecting functional layer will be referred to as "IR layer".

**Tables 5 (a) and (b) Composition and thicknesses of the low-e coating and the noble gas concentration in sputtering atmosphere, starting from the glass substrate.**

| Ex.1 | | | | |
|---|---|---|---|---|
| | Layer | Thickness (nm) | Noble gas concentration in sputtering atmosphere expressed in volume ratio | Other gas concentration in the sputtering atmosphere expressed in volume ratio |
| Dielectric coating | ZSO5 | 37 | 0 | 100% oxygen |
| | ZnO:Al | 5 | 0 | 100% oxygen |
| IR layer | Ag | 13 | 100% argon | 0 |
| Barrier layer | Ti | 2 | 100% argon | 0 |
| Dielectric coating | ZSO5 | 45 | 0 | 100% oxygen |
| | ZnO:Al | 12 | 0 | 100% oxygen |
| IR layer | Ag | 13 | 100% argon | 0 |
| Barrier layer | Ti | 2 | 100% argon | 0 |
| Dielectric coating | ZSO5 | 28 | 0 | 100% oxygen |
| | TiO₂ | 1 | 45% argon | 55% oxygen |

| Ex.2 | | | | |
|---|---|---|---|---|
| Comparative example | | | | |
| | Layer | Thickness (n m) | Noble gas concentration in sputtering atmosphere expressed in volume ratio | Other gas concentration in the sputtering atmosphere expressed in volume ratio |
| Dielectric coating | ZSO5 | 13 | 20% argon | 80% oxygen |
| | TZO | 21 | 90% argon | 10% oxygen |
| | ZnO:Al | 6 | 20% argon | 80% oxygen |
| IR layer | Ag | 10 | 100% argon | 0 |
| Barrier layer | AZO | 7 | 100% argon | 0 |
| Dielectric coating | ZSO5 | 11 | 20% argon | 80% oxygen |
| | SiN | 24 | Minimum argon | nitrogen |
| | TZO | 6 | 90% argon | 10% oxygen |

For the SiN (silicon nitride) , the sputtering gas is a mixture of nitrogen and argon in which nitrogen ratio is adjusted in such a way that the SiN is a fully nitrided layer of Si₃N₄. In this example, the amount of argon is around 40% of the total gas volume.

As showed in Tables 5 (a) and (b), the inventors have now found that when the sputtered low-e coating is deposited with a noble gas present in the mixture of sputtering gases, the resulting layers are contaminated with said noble gas in such an extent that it might be critical afterwards for a VIG assembly. The inventors have therefore found that is critical to adjust the deposition conditions of the different layers forming the low-e coating to obtain a limited amount of noble gas release, in particular a limited amount or argon release wherein the corresponding coated glass pane is assembled within a VIG unit. This is better illustrated in the Fig.1 showing XPS analysis on the 2 different low-e stacks of table 2. This figure clearly shows that the atomic concentration of said noble gas, namely argon, is higher in Ex.2 in contrast to the concentration of argon of the low-e coating of ex.1 which is lower and relatively constant.

A second analysis is presented in Figure 2 and has been carried on the same 2 coated glass panes of examples (Ex.1 and Ex.2) to trace the argon release while samples are kept warm under vacuum. Fig.2 shows that argon release drops more rapidly to a limit in the Ex.1 sample, while it takes some more time for the other sample (Ex.2) to reach the same level. In fact the argon level took 2 hours to be reached with Ex.1 and almost 6 hours with Ex.2. Argon amount has been monitored with help of a high sensitive quadrupole mass spectrometer. Therefore, Figure 2 illustrates the release of argon over time when subjected to a temperature profile that mimics the temperature profile of the production process, during the vacuum exhaustion phase. The coated glass pane has been subjected to a temperature increase to 450° C, slightly decreased to 400° C and then maintained while the degasification started. Figure 2 illustrates that the release of argon over time for the coated glass pane of example 2 is much slower than for the coated glass pane of example 1. The present invention is therefore based on the surprising technical effect that non only the total amount of argon released for the low-e coating should be carefully monitored but also the diffusion kinetics of argon through the low-e coating should be taken into account. Figure 2 illustrates that a much longer period is required to exhaust argon for coated glass pane of example 2. Therefore, in one embodiment, the present invention is based on criticality of adjusting the deposition conditions of the different layers forming the low-e coating to obtain a limited amount of noble gas release, in particular a limited amount or argon release, wherein the corresponding coated glass pane is assembled within a VIG unit. In a second embodiment, the present invention is based on the criticality of the noble gas release kinetics and hence teaches to subject the coated glass pane to a high temperature for a dedicated period of time before assembly within a glazing. The separate heating step avoids an unnecessary long period of degasification during the VIG assembly process and so helps to maintain the production cost of the corresponding VIG assembly reasonable.

We have decided to characterize the low-e coating of the invention through the Static Outgassing Technic which involve a well-defined outgassing of the low-e coating and measurement of the gases released through RGA analyses method. The implemented method is here identified as the "outgassing noble gas measurement" (ONGM) and is defined below. This method shows that the argon release is directly connected to the argon amount present in the low-e coating and allows to characterise the low-e coating of the invention.

To determine the releasable Argon content, a sample of glass coated of 20 mm x 30 mm is introduced in an hermetically sealed flask. The flask is connected to a vacuum pump and the atmosphere of the flask is vacuum pumped overnight up to reach a residual pressure lower than 10⁻⁶ mbar. The flask is then completely isolated and is subjected to a heating program conform to the following temperature profile: heating ramp from room temperature to 460° C within 100 minutes, stay at 460° C for 20 minutes and cooling ramp from 460° C to room temperature within 100 minutes. When this degassing protocol has been completed, the total amount of outgassed species are collected, sampled and analysed by a quadrupole mass spectrometer at a temperature equal to 23° C through the known RGA method. The amount of outgassed species is expressed in mbar.cm³ and is thus a direct indication of the quantity of gas present in the sample. This quantity (directly proportional to the molar amount of the gas) is divided by total surface of the sample submitted to the analysis (expressed in mm) and is expressed in mbar.cm³ per mm² of coated glass.

The two low-e layer stacks of the coated glass panes of Ex.1 and Ex.2 have been submitted to the ONGM method and results are given in table 6.

**Table 6 Noble gas (argon) measured by ONGM method in low-e stacks**

| Stack | Noble gas (argon) amount (mbar.cm³/mm²) |
|---|---|
| Ex.1 | 0.28 × 10⁻⁶ |
| Ex.2 | 2.5 × 10⁻⁶ |

The noble gas amount in Ex.2 which is the counter-example proves to be about ten times greater than the amount of Ex.1, confirming that this characteristic is an important feature to get a performing VIG. It has been found that to keep the performance and the sustainability of a glazing unit comprising a coated glass pane wherein such coating comprise layers that have been deposited under a noble gas atmosphere; especially the performance and sustainability of a VIG comprising such coated glass pane; that such amount of noble gas must be carefully limited so as to avoid excessive and **long** release over time. Therefore, the coated glass pane of the present invention must present a releasable noble gas content per coated surface area of the coated glass pane, at a pressure of less than 10⁻⁶ mbar and after heating from room temperature to 460° C in 100 minutes, maintaining at 460° C for 20 minutes, cooling from 460° C to 23° C in 100 minutes is less than 1.5 × 10⁻⁶ mbar.cm³ per mm² of coated glass pane.

Different approaches are possible to allow depositing a low-e coating using magnetron sputtering process that fulfil the noble gas threshold defined by the invention. With the objective to illustrate the invention and in no way limiting it, we define below some tuned conditions starting from a conventional low-e coating in order to obtain a stack conform to this invention.

Practically, a low-e coating similar to the one of Ex.2, except that the last TZO layer that can be considered as the protective coat layer, has been cancelled and the stack has been prepared through modified sputtering conditions.

Typically the deposition employs vacuum deposition chambers, conveyors for the substrate, power sources and gas entry locks. Each deposition chamber contains a magnetron sputtering cathodes, gas inlets and evacuation outlet. Each deposition chamber is characterised by its own atmosphere. The cathodes may be built from a metallic or a ceramic material. A float glass sheet is washed and introduced in the sputtering device. The glass pane is facing the target and operating conditions as the requested sputtering atmosphere is regulated in each sputtering chamber.

In the table 7, we summarised the sputtering conditions for examples ex.2 with unmodified deposition process and for new ex.3) with modified deposition process. In addition to the removal of the protective coat layer TZO, the typical sputtering conditions used to produce the coated glass pane of example 2 have been modified as per example 3 to produce the specific coated glass pane of the present invention. For the process, in all sputtering chambers, absolute pressure is comprised between 5 to 7 mTorr (6.6 mbar to 9.3 mbar) and process is conducted at room temperature.

**Table 7. Modified and unmodified sputtering conditions**

| | layers | target | Volume ratio of noble gas in the sputtering atmosphere (%) | |
|---|---|---|---|---|
| | | | Unmodified process (Ex.2) | Modified Process (Ex.3) |
| Dielectric coating | ZSO5 | ZnSn (52.4% Zn) | 20 | 0 |
| | TZO | TiZrOx | 90 | 90 |
| | ZnO:Al | Zn:Al | 20 | 0 |
| IR layer | Ag | Ag | 100 | 100 |
| Barrier layer | AZO | ZnO:Al | 100 | 100 |
| Dielectric coating | ZSO5 | ZnSn (52.4% Zn) | 20 | 0 |
| | SiN | Si:AI | minimum | minimum |
| | *(TZO)* | *TiZrOx* | 90 | *Non Applicable* |

In another example the coated glass pane of example Ex.2 has been heat treated at a temperature of 480° C during 8 hours, under normal atmospheric pressure. By this procedure we obtained a new sample Ex.4. The conditions given above are only one example. Similar results may be reached by using lower temperature with higher heating duration or with lower pressure or both. Alternative conditions are given in the table 8 below.

**Table 8 conditions for the heat treatment of a low-e coating in order to remove excess of noble gas which is incorporated in the coating.**

| Temperature (° C) | Time (hours) | Pressure (mbar) |
|---|---|---|
| 300-500 | 1-12 | 0.1-1000 |

Each of the resulting coating of examples 2 to 4 has been asserted through the ONGM method and results are given in the table 9. Table 9 Argon incorporation in the low-e stacks of examples 2 to 4.

| | Sputtering conditions | Treatment | ONGM Ar (mbar.cm³/mm²) |
|---|---|---|---|
| Ex.2 Comparative example | Unmodified | No | 2.5 × 10⁻⁶ |
| Ex.3 | Modified as indicated in Table 7 | No | 0.23 × 10⁻⁶ |
| Ex.4 | Unmodified | heat-treated at 480° C during 8 hours, under normal atmospheric pressure | 0.25 × 10⁻⁶ |

In order to confirm that a VIG unit assembled with a coated glass pane which fulfils the ONGM specification will also allow to reach a high thermal performance, characterised through a thermal coefficient U value not greater of 1.00 W/m²K, we incorporated the coated glass panes of Ex.3 and of Ex.4 into VIG unit. The VIG unit obtained are named respectively, the VIG ex.3 and VIG ex.4. Performance of the resulting VIG units have been evaluated and are given in table 10 in comparison with the counter-example VIG ex.2.

**Table 10. VIG thermal performances**

| | VIG ex.2 Comparative example | VIG ex.3 | VIG ex.4 |
|---|---|---|---|
| U (W/m²K) | 1.5 | 0.86 | 0.86 |
| Emissivity | 0.032 | 0.036 | 0.031 |

The VIG examples Ex.3 and Ex.4 are conform to the invention. As indicated in Table 9 above, the level of argon measured by the ONGM method for coated glass panes examples 3 and 4 is below 1.5 × 10⁻⁶ mbar.cm³/mm² even below 1.0 × 10⁻⁶ mbar.cm³/mm² in the defined test conditions. In contrast, the level of argon measured by the ONGM method for the comparative coated glass pane of example 2 is above the limit of 1.5 × 10⁻⁶ mbar.cm³/mm² of coated glass pane. The VIG unit incorporating those low-e coated glass panes shows good thermal performances. On the contrary, the counter example Ex.2, made with a coated glass pane having a too high argon level, i.e. 2.5 × 10⁻⁶ mbar.cm³/mm², prove to fail the insulation test and will be disregard in view of their insulation performance. Indeed, the thermal performance of glazing unit is assessed via the calculation of the thermal transmittance U that takes into account the conduction, convection and radiation phenomena within the glazing unit. The presence of a low-e coating within the glazing unit allows to reduce the radiative contribution to the thermal transmittance and is measured via the emissivity. Table 10 indeed illustrates that despites similar emissivity performance of the 3 low-e coating tested, the thermal performance of the VIG ex.2 is very high. Such bad thermal performance is due to the presence of noble gas within the vacuum space that substantially increase the convention contribution within the thermal transmittance.

The tables below provides further examples of compositions and sputtering conditions of coated glass panes of the present invention (ex.5 and ex.6)

| **EXAMPLE 5** | Target | Thickness (nm) | Gas composition in the sputtering atmosphere (%) |
|---|---|---|---|
| layers | | | |
| From the glass substrate: | | | |
| ZSO5 | ZnSn (52.4% Zn) | 18 | 100% Oxygen |
| TZO | TiZrOx | 22 | 90% Argon and 10% Oxygen |
| ZnO:Al | Zn:Al | 5 | 100% Oxygen |
| Ag | Ag | 13 | 100% Argon |
| AZO | ZnO:Al | 5 | 100% Argon |
| ZSO5 | ZnSn (52.4% Zn) | 18 | 100% Oxygen |
| SiN | Si:Al | 24 | 40% argon and 60% nitrogen |

| **EXAMPLE 6** | | | Gas composition in the sputtering atmosphere (%) |
|---|---|---|---|
| Layers | Target | Thickness (nm) | |
| From the glass substrate: | | | |
| ZSO5 | ZnSn (52.4% Zn) | 35 | 100% Oxygen |
| ZnO:Al | Zn:Al | 5 | 100% Oxygen |
| Ag | Ag | 13 | 100% Argon |
| AZO | ZnO:Al | 5 | 100% Argon |
| ZSO5 | ZnSn (52.4% Zn) | 4 | 100% Oxygen |
| SiN | Si:Al | 6 | 40% argon and 60% nitrogen |
| SiN | Si:Al | 18 | 40% argon and 60% nitrogen |
| ZSO5 | ZnSn (52.4% Zn) | 10 | 100% oxygen |
| TZO | TiZrOx | 3 | 100% oxygen |
| ZnO:Al | ZN:Al | 5 | 100% oxygen |
| Ag | Ag | 14 | 100% argon |
| AZO | ZNO:Al | 8 | 100% argon |
| ZSO5 | ZnSn (52.4% Zn) | 8 | 100% oxygen |
| SiN | Si:Al | 25 | 40% argon and 60% nitrogen |

## Claims

1. A method for the production of a coated glass pane wherein said coated glass pane is heat treated at a temperature greater than 300C, preferably 400C and more preferably 480C; wherein said
coated glass pane comprises a glass substrate provided with a low-e coating comprising:
a) an alternating arrangement of n infrared radiation reflecting functional layers and n+1 dielectric coatings, with n ≥ 1,
a. such that each infrared radiation reflecting functional layer is surrounded by dielectric coatings, the dielectric coating comprising one or more dielectric layers, and
b. such that each infrared radiation reflecting functional layer is protected by a barrier layer directly above and contacting it,
wherein at least one layer other than each infrared radiation reflecting functional layer and the barrier layer comprises a noble gas, preferably argon,
b) optionally, a protective topcoat, optionally comprising one or more dielectric layers;
c) optionally a seeding layer, optionally comprising a dielectric layer, below and in contact with at least one infrared radiation reflecting functional layer;
wherein the at least one layer other than each infrared radiation reflecting functional layer and the barrier layer, is a dielectric layer from within the dielectric coating, the seeding layer and/or the protective topcoat and wherein the total geometrical thickness of the dielectric layers deposited under noble gas-comprising atmosphere is at least 30 nm and not more than 120 nm; and
wherein the releasable noble gas content per coated surface area of said coated glass pane, at a pressure of less than 10⁻⁶ mbar and after heating from room temperature to 460° C in 100 minutes, maintaining at 460° C for 20 minutes, cooling from 460° C to 23° C in 100 minutes is less than 1.5 × 10⁻⁶ mbar.cm³ per mm² of coated glass pane.

2. The method of claim 1 wherein the heat treatment is made at a pressure equal to or below 1 bar, preferably equal to or below 10 mbar, more preferably equal to or below 1 mbar and most preferably equal to or below 0.1 mbar

3. The method according to any of the claims 1 to 2, wherein the heating time is at least 0.5 hour, preferably at least 2 hours and more preferably at least 6 hours.

4. The method according to any of the preceding claims wherein the releasable noble gas content per coated surface area of the coated glass pane at a pressure of less than 10⁻⁶ mbar and after heating from room temperature to 460° C in 100 minutes, maintaining at 460° C for 20 minutes, cooling from 460° C to 23° C in 100 minutes is less than 1.0 × 10⁻⁶ mbar.cm³ per mm² of coated glass preferably less than 0.5 × 10⁻⁶ mbar cm³ per mm² of coated glass pane.

5. The method according to any of the preceding claims wherein the total geometrical thickness of the dielectric layers deposited under noble gas-comprising atmosphere is at least 45 nm, alternately at least 60 nm.

6. The method according to any of the preceding claims wherein the total geometrical thickness of the low-e coating is comprised between 70 and 300 nm, preferably between 80 and 250 nm and most preferably between 90 and 190 nm.

7. The method according to of any of the preceding claims wherein the infrared radiation reflecting functional layer(s) comprise silver or consist of silver.

8. The method according to any of the preceding claims wherein the low-e coating comprises from the glass substrate outwardly a) a tin zinc oxide layer; b) a zinc oxide based layer ; c) a silver layer; d) a barrier layer; e) a dielectric coating.

9. The method according to any of the preceding claims wherein the low-e coating comprises from the glass substrate outwardly a) dielectric coating comprising a tin zinc oxide layer; b) a seeding layer comprising a zinc oxide based layer ; c) a silver infrared radiation reflecting functional layer; d) a barrier layer; e) a dielectric coating; f) a zinc oxide based layer; g) a second silver infrared radiation reflecting functional layer; h) a second barrier layer; i) a dielectric coating.

10. The method according to any one of the preceding claims wherein at least one barrier layer is a metal, its oxide or nitride; the metal being chosen from the list consisting of titanium, zinc, nickel, chromium or any alloy including one of them, and more particularly is a zinc oxide.

11. The method according of any one of the preceding claims wherein at least one dielectric coating is a single or multiple dielectric layer(s) coating comprising any of the oxide or nitride of titanium, silicon, zinc, tin, zirconium or mixture thereof.

12. The method according any of the preceding claims wherein the total thickness of dielectric layers deposited in an atmosphere including argon is not more than 100 nm, preferably not more than 90 nm.

13. Use of the coated glass pane obtained by the method according to any of the preceding claims, to produce a vacuum insulating glazing.

14. Use of the coated glass plane according to claim 15 wherein the vacuum insulated glazing is **characterized by** a U value not greater of 1.00 W/m²K, more preferably not greater than 0.90 W/m²K and most preferably not greater than 0.80 W/m²K.
